# EUROPEAN PATENT APPLICATION

(11) **EP 1 710 493 A2**
(43) Date of publication of application: **11.10.2006**
(21) Application number: 06006838.4
(22) Date of filing: 31.03.2006
(51) Int. Cl.: F21V 5/04, F21V 7/00, H01L 33/00, F21K 7/00, F21Y 101/02

(54) **Vitual point light source**

(30) Priority: 05.04.2005 US 99076
(71) Applicant: OSRAM SYLVANIA INC., Danvers, MA 01923 (US)
(72) Inventor: Coushaine, Charles M., 03461 Rindge, NH (US); Johnson, Ralph, 03110 Bedford, NH (US); Sidwell, Steven C., 03229 Hopkinton, NH (US); Tessnow, Thomas, Weare NH 03281 (US); Tucker, Michael, 03242 Henniker, NH (US)
(74) Representative: Pokorny, Gerd

(57) **Abstract**

A virtual point light source (10) has a support (12) having an axis (14), a plurality of individual light emitting diodes (16) positioned on the support (12); and an individual optic (18) associated with each of the light emitting diodes (16), each of the individual optics (18) focusing the light from its associated light emitting diode (16) to a virtual point (20) on the axis (14) at a distance (D) from said support.

## Description

### TECHNICAL FIELD

This invention relates to light sources and more particularly to solid-state light sources. Still more particularly, it relates to light sources employing light emitting diodes, such light sources being capable of being used as the forward lighting system for vehicles.

### BACKGROUND ART

LED lamps have been achieving acceptance as replacements for the more common incandescent types of lamps because of their long life and reasonable power requirements. These uses are particularly present in the automotive industry where lamps employing LEDs have been used as taillights and as stoplights, such as the required center high mount stoplight (CHMSL). Many advantages could be realized if LEDs could be used for the forward lighting of automobiles; however, the employment of LEDs for headlights has been complicated by the number of LEDs necessary to provide sufficient illumination and the complexity of the lenses and/or plurality of light pipes or optical fibers necessary to duplicate the point source illumination achievable by the prior art incandescent and arc discharge bulbs.

### DISCLOSURE OF INVENTION

It is, therefore, an object of the invention to obviate the disadvantages of the prior art.

It is another object of the invention to enhance the forward light systems of vehicles.

Yet another object of the invention is the achievement of the former objects at a reasonable cost.

These objects are accomplished, in one aspect of the invention by a virtual point light source comprising: a support having an axis; a plurality of individual light emitting diodes (LED or LEDs) positioned on said support; and an individual optic associated with each of said light emitting diodes, each of said individual optics focusing the light from its associated light emitting diode to a virtual point on said axis at a distance from said support.

The provision of the individual optics for the LEDs allows for all of the emitted light from the multiple LEDs to be directed to a single focal point, where a suitable lens, such as a projection lens or a Fresnel lens can be supplied to direct the light as desired.

### BRIEF DESCRIPTION OF THE DRAWINGS

Fig. 1 is a diagrammatic plan view of an embodiment of the invention;
Fig. 2 is an elevational view, partially in section, taken along the line 2-2- of Fig. 1; and
Fig. 3 is a diagrammatic elevational view of an optic useable with an embodiment of the invention.

### BEST MODE FOR CARRYING OUT THE INVENTION

For a better understanding of the present invention, together with other and further objects, advantages and capabilities thereof, reference is made to the following disclosure and appended claims taken in conjunction with the above-described drawings.

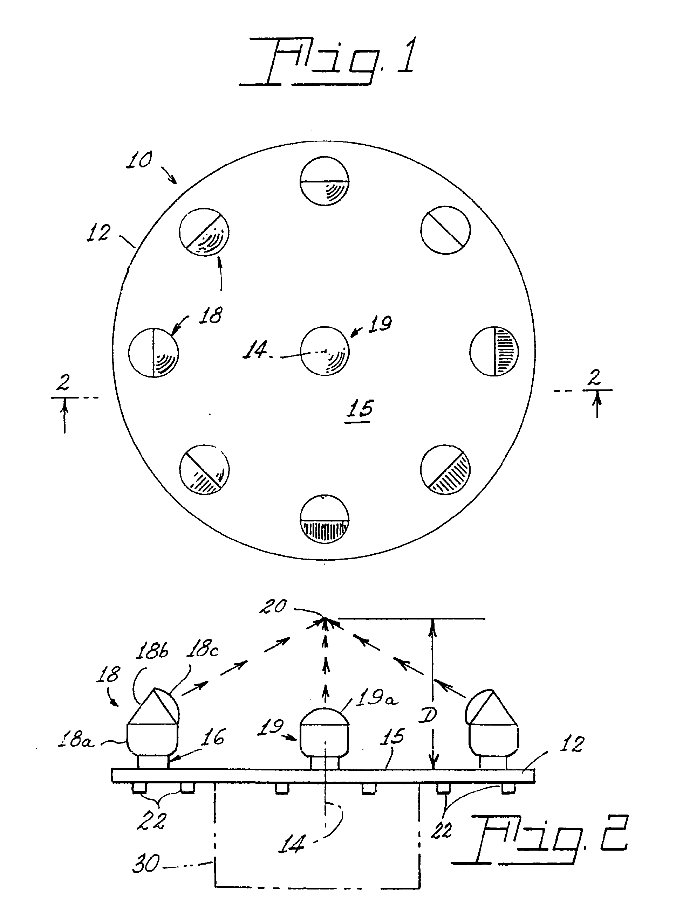

Referring now to the drawings with greater particularity, there is shown in Fig. 1 a virtual point light source 10 that has a support 12 with an axis 14. Individual LEDs 16 are positioned on the support 12 about the periphery thereof and an individual optic 18 is associated with each LED 16. Each of the individual optics 18 focuses the light from its associated light emitting diode 16 to a virtual point 20 on the axis 14 at a distance D from a surface 15 of the support 12.

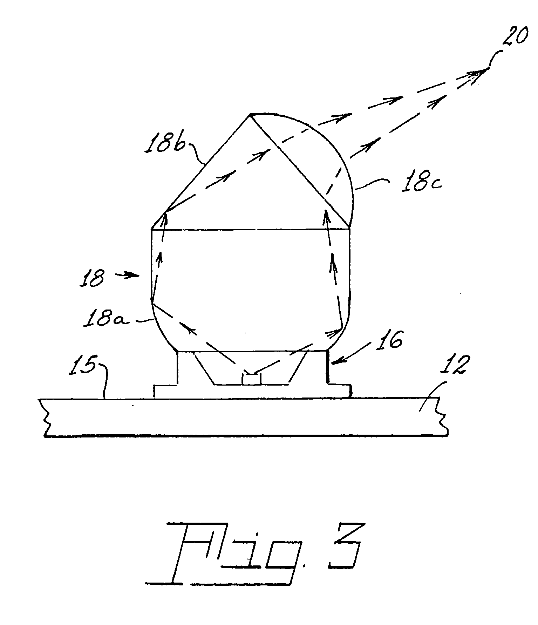

The support 12, which preferably is a circular printed circuit board with good thermal conductivity, includes circuitry 22 (shown diagrammatically in Fig. 2) for providing power to the light emitting diodes 16.

In a preferred embodiment of the invention the LEDs 16 are positioned about the periphery 24 of circular support 12 and the individual optics 18 comprise a one-piece solid structure. While glass optics can be used, it is preferred to use an optical grade plastic such as acrylic or polycarbonate.

As pictured in the drawings, the optics 18 comprise a first reflecting portion 18a adjacent the LED 16, a second reflecting portion 18b to begin concentrating the light beam and a third portion 18c to focus the beam toward the virtual point 20. Diodes 16 located at a common displacement from the axos may use similar optics 18. If a diode 16 is used on the axis, an optic 19 would be used that eliminates the second portion and employs a converging lens 19a.

If desired or necessary because of the power requirements to drive the LEDs, 16 a heat sink 30 can be attached in thermal relation to the support 12

To form a specific light output, a suitable lens (not shown) such as a projection lens or a Fresnel lens, or the focal point of such a lens, can be positioned adjacent the virtual point 20.

There is thus provided a small, convenient solid-state light source that can be used for the forward lighting of a vehicle. The individual LEDs are dispersed for good heat sinking, while the emitted light is concentrated for improved intensity and beam control. The use of a plurality of LEDs all directing their individual light outputs to a virtual point simulates the prior art light sources that used incandescent or arc discharge units; however, the light source provided by the invention has a much longer life and is much more rugged. While the virtual light source 10 can supply illumination to light pipes or other optical fibers, such elements are not necessary since the output of the light at the virtual point source can be fed directly to a dispersing lens.

While there have been shown and described what are present considered to be the preferred embodiments of the invention, it will be apparent to those skilled in the art that various changes and modifications can be made herein without departing from the scope of the invention as defined by the appended claims.

## Claims

1. A virtual point light source comprising:
a support having an axis;
a plurality of individual light emitting diodes positioned on said support; and
an individual optic associated with each of said light emitting diodes, each of said individual optics focusing the light from its associated light emitting diode to a common virtual point at a distance from said support.

2. The virtual point light source of Claim 1 wherein said support includes circuitry for providing power to said light emitting diodes.

3. The virtual point light source or Claim 2 wherein said support is circular.

4. The virtual point light source of Claim 3 wherein at least some of said light emitting diodes are positioned about the periphery of said circular support.

5. The virtual point light source of Claim 4 wherein said each of said individual optics comprise a one-piece solid structure.

6. The virtual point light source of Claim 1 wherein said virtual point is on said axis.
